Europäisches Patentamt

European Patent Office

Office européen des brevets

(11) Publication number: **0 035 846**
**A2**

(12) **EUROPEAN PATENT APPLICATION**

(21) Application number: **81300794.5**

(22) Date of filing: **26.02.81**

(51) Int. Cl.³: **G 01 R 23/15**

(30) Priority: **07.03.80 GB 8007874**

(43) Date of publication of application:
**16.09.81 Bulletin 81/37**

(84) Designated Contracting States:
**CH DE FR LI SE**

(71) Applicant: **WESTINGHOUSE BRAKE AND SIGNAL COMPANY LIMITED**
**Foundry Lane**
**Chippenham Wiltshire SN15 1RT(GB)**

(72) Inventor: **Brown, Christopher Robert**
**Westinghouse Signals P.O.Box 79**
**Chippenham Wiltshire SN15 1JD(GB)**

(74) Representative: **Page, Edmund John**
**WESTINGHOUSE BRAKE AND SIGNAL COMPANY**
**LIMITED P.O.Box 85 Foundry Lane**
**Chippenham Wiltshire SN15 1RT(GB)**

(54) **Frequency check apparatus.**

(57) A frequency check apparatus, for example, for a GO/NO GO control function in a chopper controlled traction motor control system is required to permit operation at only the correct chopper frequency and also normal start up from rest when the chopper frequency is zero. A conventional band-pass filter type frequency sensing channel (2) discriminates between operation at correct and incorrect frequencies but cannot respond in the required manner to zero frequency.

To permit zero-frequency detection a signal generator (11) is coupled to a second and appropriately responsive channel (3) via a saturable magnetic circuit (13) which is also coupled to the frequency carrying conductor (4). At any operating frequency the magnetic circuit (13) is saturated and the second channel (3) is blocked so that the control function is provided by the first channel (2). At zero operating frequency the signal generator (11) is not blocked and while the first channel (2) is not energised the control function is provided by the second channel (3). The outputs of the first and second channels are connected via an OR gate (1).

./...

FIG.1

0035846

Frequency Check Apparatus.

The invention relates to frequency check apparatus used, particularly but not exclusively, as a control responsive to the correct production of a frequency to perform a control function or, alternatively, responsive to the incorrect production of a frequency to perform a further control function.

According to the invention, there is provided frequency check apparatus for checking that the frequency of an electrical signal carried by a conductor has a predetermined frequency comprising a first frequency sensing channel the input of which is coupled to the conductor and the output of which is arranged to occupy a first state if a signal on the conductor has the predetermined frequency and a second state otherwise, a saturable magnetic circuit inductively coupled to the conductor and adapted to be saturated by a signal thereon and also arranged to provide inductive coupling between a signal generator and a second sensing channel the output of which is arranged to occupy a first state if the output of the signal generator is sensed and a second state if a signal on the conductor saturates the coupling and, the two sensing channels are connected to an OR gate the output of which therefore occupies a first state if the conductor carries a signal having the predetermined frequency or a signal is absent and a second state if the signal has an incorrect frequency.

For a better understanding of the invention and to show how the same may be carried into effect, reference will now be made tothe two Figures of the drawings, in which

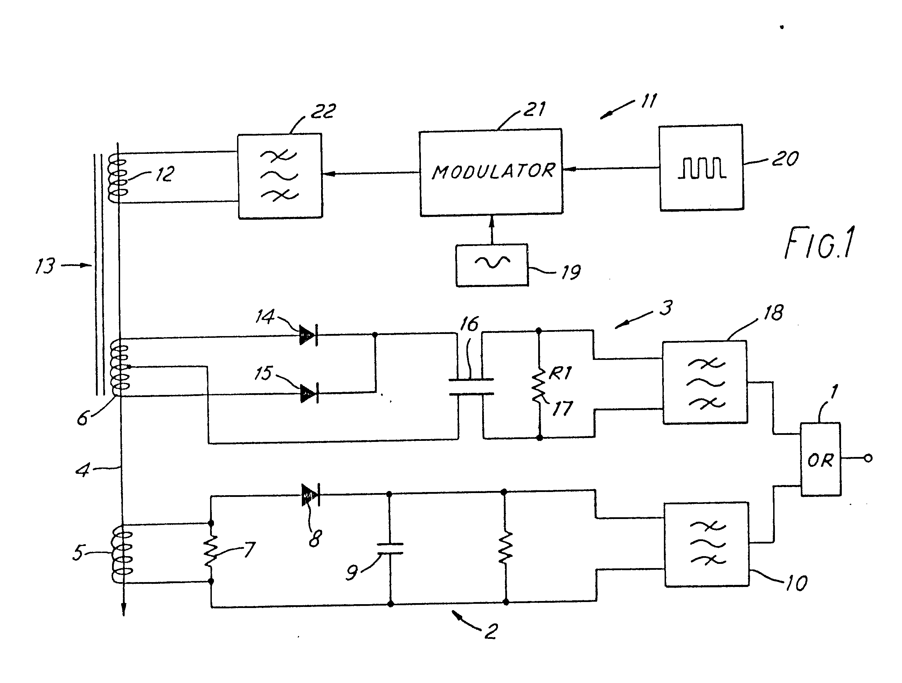

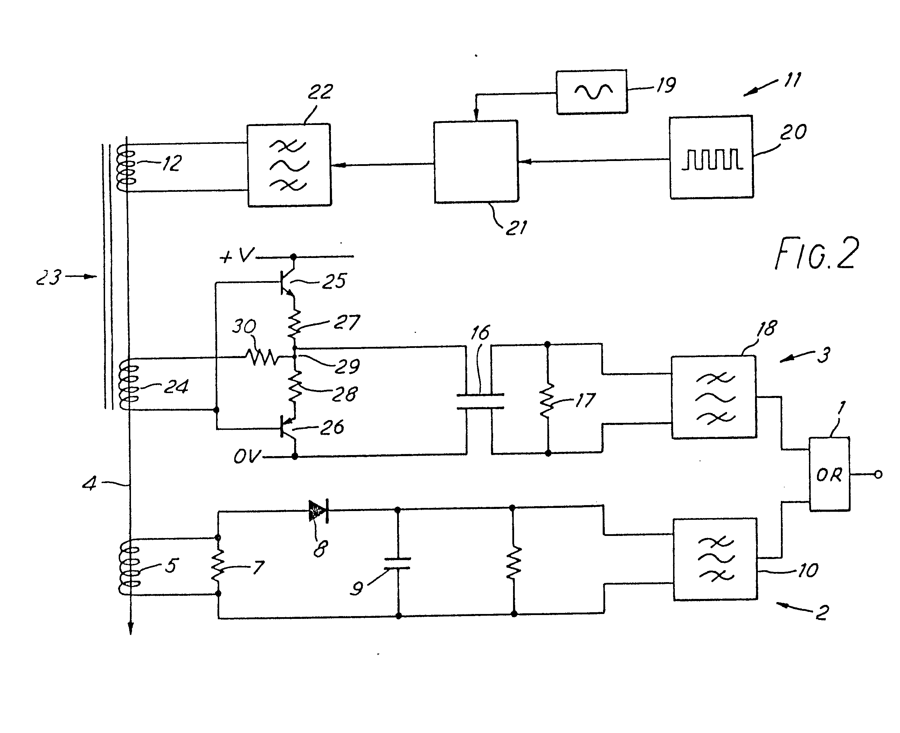

Fig. 1 and Fig. 2 diagrammatically illustrate circuit diagrams of alternative frequency check circuits for monitoring the frequency at which a traction motor is pulsed.

Referring now to Fig. 1, there is shown OR gating means comprising a two-input OR gate 1, the first input of which is connected to a first frequency sensing means, generally indicated by reference 2, comprising a frequency selective channel to be further described below, and the second input of which is connected to a second frequency sensing channel, generally indicated by reference 3, also to be further described below. The signal whose frequency is to be monitored is carried by a first transformer winding 4 shown in the drawing as a single rectilinear conductor, and the inputs to the frequency sensing channels 2 and 3 are derived by second and third windings 5 and 6 respectively, inductively linked with the first winding 4. The first frequency sensing channel 2 basically comprises a half-wave rectifier, having input resistor 7, diode 8 and capacitor 9 connected as shown between the transformer winding 5 and the input of a pass band filter 10 the output of which is connected to one of the inputs of OR gate 1. The pass band of filter 10 possesses a very narrow band width centred on the predetermined correct frequency of the signal to be carried by conductor 4, so that in normal operation, the first frequency sensing channel only produces an output to the OR gate 1 when the monitored signal possesses the correct frequency.

The input of the second frequency sensing channel 2, besides being inductively coupled with the conductor 4, is also inductively coupled with a further signal generator generally indicated by reference 11 which, in the illustrated embodiment, produces an amplitude modulated carrier frequency which is injected by means of a third transformer winding 12 onto the core 13 for transmission to the winding 6 at the input of the second frequency sensing channel 3. The winding 6 comprises a centre-tapped winding connected in combination with a full-wave rectifier, diodes 14, 15 which, together with capacitor 16 and resistor 17 form a demodulating circuit to recover the modulating frequency of the signal from generator 11. This modulating frequency signal is then passed to another pass band filter 18, the output of which is connected to the second input of OR gate 1. The turns ratio of windings 6 and 12 and the secondary load impedances therefor are arranged such that when a signal is present in conductor 4, the magnetic circuit 13 is saturated such that the signal injected by generator 11 via winding 12 is effectively blocked.

The signal generator 11 comprises a carrier signal generator 19, which may operate at any convenient frequency, a modulation signal generator 20, which may also operate at any convenient frequency but preferably not at, or close to, the correct frequency of the monitored signal, a signal modulator circuit 21, the output of which is connected to a pass band filter 22, the centre frequency of which is the same as the carrier frequency, and which feeds winding 12. In the second frequency channel 3, the filter 18 possesses a pass band centred on the modulation frequency of oscillator 20 in channel 11 so that, when no pulsed or alternating current is present on conductor 4 to effectively block reception of the modulated carrier signal by winding 6, the said signal will be demodulated and filter 18 will produce a signal at the second input to OR gate 1.

Thus, in operation of the frequency check circuit means, if the conductor 4 carries no pulsed or alternating current, i.e. its signal has zero frequency, there will be no sensing input to the first frequency sensing channel 2 and, the input to the second frequency 3 will not be blocked and that channel will receive a modulated carrier signal from the signal generator 11. Therefore, the first input to OR gate 1 from filter 10 in the first channel 2, will be de-energised and the second input to OR gate 1 from filter 18 in the second sensing channel 3 will be energised so that OR gate 1 will produce an output in a first or energised state.

If a pulsed or alternating current of the correct frequency is present on conductor 4, then the first sensing channel 2 will be energised and filter 10 will produce an energised output at the first input to OR gate 1. In the second frequency sensing channel 3, the saturable magnetic circuit 13 will be saturated by the presence of a pulsed or alternating current in conductor 4, so no modulated carrier signal from signal generator 11 will be received by the frequency sensing means. Thus, filter 18 will not produce an energised output at the second input to OR gate 1. In this condition, OR gate 1 will still produce an output in the first or energised state.

In a further possible operational state, the pulsed or alternating current in conductor 4 is present but has an incorrect frequency. In this case, frequency sensing channel 2 is again energised but filter 10 prevents an energising signal appearing at the first input to OR gate 1. In the second frequency sensing channel 3, magnetic circuit 13 is again saturated effectively blocking reception of the modulated carrier signal from generator 11 so that filter 18 also does not produce an energising output on the second input to OR gate 1. Thus, OR gate 1 receives no energising signal on either input and therefore its output occupies a second or de-energised state. In these circumstances, an energising signal would not appear at an input to OR gate 1 until either the pulsed or alternating current in conductor 4 again has the correct frequency and the output of the first sensing channel 2 switches to an energised state, or the signal in conductor 4 is removed, i.e. has zero frequency.

An alternative embodiment of the invention uses an electrical circuit construction, functionally similar to that already described and which is illustrated in Fig. 2, in which like parts have like references. Comparisons of Figs. 1 and 2 will show that the amplitude modulated carrier frequency generator 11 and the second frequency sensing channel 2 of Fig. 1 are retained in the Fig. 2 embodiment. In place of the previously described saturable magnetic circuit 13 linking sensing channel 3 with generator 11, a conventional non-saturable magnetic circuit 23 is employed, which in the embodiment being described is a less costly alternative and requires less critical design performance. The input for sensing channel 3 is now obtained using a two-terminal inductive winding 24 connected to a transistorised limiting d.c. restoring circuit in place of the full-wave rectifier arrangement shown in Fig. 1.

The d.c. restoring circuit comprises a pair of complementary transistors 25, 26, connected in push-pull configuration between the supply rails 0v and +V of a low voltage power supply, typically 5volts. Resistors 27, 28 are connected in the emitter leads of respective transistors to form a common junction 29 which is connected to one terminal of four terminal
capacitor 16 so as to provide a rectified input
signal and, also through a resistor 30 to one end
of winding 24, to provide a floating reference point
for the induced voltage.  The opposite terminal of
winding 24 is connected directly to the base terminals
of both transistors 25, 26.  Thus, the transistors are
alternatively biassed on in  accordance with the sense
of the input voltage induced in winding 24 and the
voltage excursion of junction 29 is thereby effectively
a rectified signal limited to slightly less, by the
transistors' saturation voltage drop, than the power
supply voltages.  Where required by its application,
as will be described in more detail below, the power
supply is preferably "fail-safe", by which is meant
that its output voltage cannot exceed its design
output voltage under any circumstances, including
internal fault conditions, and can only fail to
zero volts output.

In one application of the invention, the alternating
current in conductor 4 is the pulsed signal for a
chopper- controlled traction equipment for an electrically driven rail vehicle, and the frequency check
circuit forms a go/no-go circuit designed to permit
chopper operation at only its designed frequency and,
of course, steady full motor current.  In this instance,
and energised signal at the output of OR gate 1 represents a "go" condition and a de-energised output
from OR gate 1 represents a "no-go" condition which may be connected to further control means arranged to inhibit chopper operation.

In rail transportation applications, it is preferable, indeed usually compulsory, to design electrical and electronic circuits to fail-safe design standards. With respect to the above-described embodiment therefore, the filters 10, 18 and 22 may be of conventional fail-safe design and capacitor 16 is of the four-terminal type so that no energising signal may reach filter 18 unless capacitor 16 is in circuit and thus a false energised state cannot appear at the output of filter 18. A short circuit across windings 5, 6 and/or 12, or an open circuit of any winding in any event is safe since at generator 11, this results in no output signal and in frequency sensing channel 2, this results in no input signal. In frequency sensing channel 3, a short-circuited rectifier 14 or 15 is also a failed-safe condition since this results in an absence of demodulator output and, hence, no input to filter 18. Finally, OR gate 1 is also constructed to a fail-safe design so that failure of any of its constituant components results in production of a de-energised output.

CLAIMS

1.  A frequency check apparatus for checking that the frequency of an electrical signal carried by a conductor (4) has a predetermined frequency characterised by a first frequency sensing channel (2) the input of which is coupled to the conductor (4) and the output of which is arranged to occupy a first state if a signal on the conductor (4) has the predetermined frequency and a second state otherwise, a saturable magnetic circuit (13) inductively coupled to the conductor (4) and adapted to be saturated by a signal thereon and also arranged to provide inductive coupling between a signal generator (11) and a second sensing channel (3) the output of which is arranged to occupy a first state if the output of the signal generator (11) is sensed and second state if a signal on the conductor (4) saturates the coupling and, the two sensing channels (2, 3) are connected to an OR gate (1) the output of which therefore occupies a first state if the conductor (4) carries a signal having the predetermined frequency or a signal is absent and a second state if the signal has an incorrect frequency.

2.  Frequency check apparatus according to Claim 1, wherein the saturable magnetic circuit (13) comprises a transformer having a first winding (5) coupled to the conductor (4), a second winding (12) connected to receive the output of the signal generator (11) and a third winding (6) connected to supply an input signal to the second sensing channel (3), the arrangement being such that a signal in the conductor (4) will normally produce saturation of the transformer core (13) so as to effectively block inductive coupling between the second (12) and third windings (6) and energisation of the second sensing channel by the output of the signal generator (11).

3. Frequency check apparatus according to Claim 2, wherein the third winding (4) is connected in combination with rectifying means (14, 15) in the input of the second sensing channel (3).

4. Frequency check apparatus according to Claim 3, wherein the third winding (6) is centre tapped and the rectifying means (14, 15) is arranged for full-wave operation.

5. Frequency check apparatus according to any preceding claim, wherein the signal generator (11) includes carrier signal generating means (19), signal moudlating means (21) and modulation signal generating means (20) and, in the second sensing channel (3), signal demodulating. means (14, 15, 16, 17) connected by means of signal filter means (18) responsive to the modulating signal frequency to provide the channel output.

6. Frequency check apparatus according to Claim 3 or Claim 4 or, Claim 5 when dependent thereon, wherein the signal demodulating means (14, 15, 16, 17) includes rectifying means (14, 15) and a parallel connected four-terminal capacitor (16).

7. Frequency check apparatus according to Claim 5 or Claim 6, wherein the second sensing channel further includes pass-band filter means (18) responsive to the signal modulation frequency.

8. Frequency check apparatus according to any preceding claim, wherein the first frequency sensing channel includes pass-band filter means (10).

9. "Go/No-Go" circuit means including frequency check apparatus according to any preceding claim, wherein an output signal from the OR gating means (1) in one state represents a "Go" circuit signal and in the alternative state represents a "No-Go" circuit signal.

FIG.1

FIG.2